# EUROPEAN PATENT APPLICATION

(11) **EP 4 694 097 A2**
(43) Date of publication of application: **11.02.2026**
(21) Application number: 24788991.8
(22) Date of filing: 09.04.2024
(51) Int. Cl.: H04M 1/02, H05K 1/14, H05K 5/00

(54) **CONNECTING MEMBER AND ELECTRONIC DEVICE COMPRISING SAME**

(30) Priority: 11.04.2023 KR 20230047671; 15.06.2023 KR 20230076694
(71) Applicant: Samsung Electronics Co., Ltd., Suwon-si, Gyeonggi-do 16677 (KR)
(72) Inventor: LEE, Kyungrok, Suwon-si Gyeonggi-do 16677 (KR); KIM, Wonseob, Suwon-si Gyeonggi-do 16677 (KR); BAE, Bumhee, Suwon-si Gyeonggi-do 16677 (KR); YANG, Kwangmo, Suwon-si Gyeonggi-do 16677 (KR); LEE, Youngchul, Suwon-si Gyeonggi-do 16677 (KR); JANG, Changwon, Suwon-si Gyeonggi-do 16677 (KR); CHO, Sujin, Suwon-si Gyeonggi-do 16677 (KR)
(74) Representative: HGF
(86) International application number: PCT/KR2024/004713
(87) International publication number: WO 2024/215049

(57) **Abstract**

An electronic device according to an embodiment of the present disclosure may comprise: a housing including at least one first conductive portion segmented along at least a portion of a sidewall and a second conductive portion disposed on the inner side of the sidewall and spaced apart from the first conductive portion; a connecting member electrically connecting the first conductive portion to the second conductive portion; and a printed circuit board disposed inside the housing and electrically connected to the first conductive portion through the connecting member. The connecting member may include a first metal layer configured to have at least a portion bonded to the first conductive portion, a second metal layer configured to have at least a portion bonded to the second conductive portion, and a dielectric layer disposed between the first metal layer and the second metal layer.

## Description

### [Technical Field]

An embodiment of the disclosure relates to a connecting member and an electronic device including the same.

### [Background Art]

With the remarkable development of information communication technology, semiconductor technology, and the like, the distribution and use of various electronic devices are rapidly increasing. In particular, recent electronic devices are being developed to be portable and capable of communication.

The term "electronic device" may refer to a device that performs a specific function according to an installed program, such as a home appliance, an electronic scheduler, a portable multimedia player, a mobile communication terminal, a tablet PC, an image and sound device, a desktop or laptop PC, or a vehicle navigation system. For example, these electronic devices may output stored information as sound or images. As the degree of integration of electronic devices increases and ultra-high-speed and high-capacity wireless communication become more widespread, a single electronic device, such as a mobile communication terminal, may be now equipped with various functions. For example, not only communication functions but also entertainment functions such as gaming, multimedia functions such as music and video playback, communication and security functions such as mobile banking, as well as schedule management and electronic wallet functions, are being integrated into a single electronic device. These electronic devices are being miniaturized to be conveniently carried by users.

### [Detailed Description of the Invention]

### [Technical Solution]

According to an embodiment of the disclosure, an electronic device may include a housing including at least one first conductive portion that is segmented along at least a portion of a side wall, and a second conductive portion disposed inside the side wall and spaced apart from the first conductive portion, a connecting member electrically connecting the first conductive portion and the second conductive portion, and a printed circuit board disposed within the housing and electrically connected to the first conductive portion through the connecting member. The connecting member may include a first metal layer configured to be at least partially bonded to the first conductive portion, a second metal layer configured to be at least partially bonded to the second conductive portion, and a dielectric layer disposed between the first metal layer and the second metal layer.

According to an embodiment of the disclosure, an electronic device may include a housing including at least one first conductive portion that is segmented along at least a portion of a side wall, and a second conductive portion disposed inside the side wall and spaced apart from the first conductive portion, a connecting member electrically connecting the first conductive portion and the second conductive portion, and a printed circuit board disposed within the housing and electrically connected to the first conductive portion through the connecting member. The connecting member may include a first metal layer configured to be bonded to at least a portion of the first conductive portion, a second metal layer configured to be bonded to at least a portion of the second conductive portion, and a dielectric layer disposed between the first metal layer and the second metal layer. The first metal layer may be configured to be bonded to the first conductive portion through at least one of laser bonding or ultrasonic bonding, and the second metal layer may be configured to be bonded to the second conductive portion through at least one of laser bonding or ultrasonic bonding.

### [Brief Description of Drawings]

FIG. 1 is a block diagram of an electronic device according to various embodiments in a network environment.
FIG. 2 is a view illustrating an electronic device according to an embodiment of the disclosure in an unfolded state.
FIG. 3 is a view illustrating the electronic device according to an embodiment of the disclosure in a folded state.
FIG. 4 is an exploded perspective view of an electronic device according to an embodiment of the disclosure.
FIG. 5 is a view illustrating an unfolded state of an electronic device according to an embodiment of the disclosure, with internal components mounted therein.
FIG. 6 is a view illustrating a conductive portion and a connecting member according to an embodiment of the disclosure.
FIGS. 7A and 7B are front and rear perspective views of a connecting member according to an embodiment of the disclosure.
FIG. 8A is a view illustrating a state before the conductive portion of the housing and the connecting member are coupled, according to an embodiment of the disclosure.
FIGS. 8B and 8C are views illustrating a state after the conductive portion of the housing and the connecting member are coupled, according to an embodiment of the disclosure.
FIG. 9A is a view illustrating a state before the housing and the connecting member are coupled, according to an embodiment of the disclosure.
FIG. 9B is a view illustrating a state after the housing and the connecting member are coupled, according to an embodiment of the disclosure.
FIG. 10 is a cross-sectional view taken along line A-A' of FIG. 7A, illustrating the state in which the connecting member and the housing are coupled.
FIGS. 11A, 11B, and 11C are views illustrating cross-sections of the connecting member cut along line A-A' of FIG. 7B, according to an embodiment of the disclosure.

### [Mode for Carrying out the Invention]

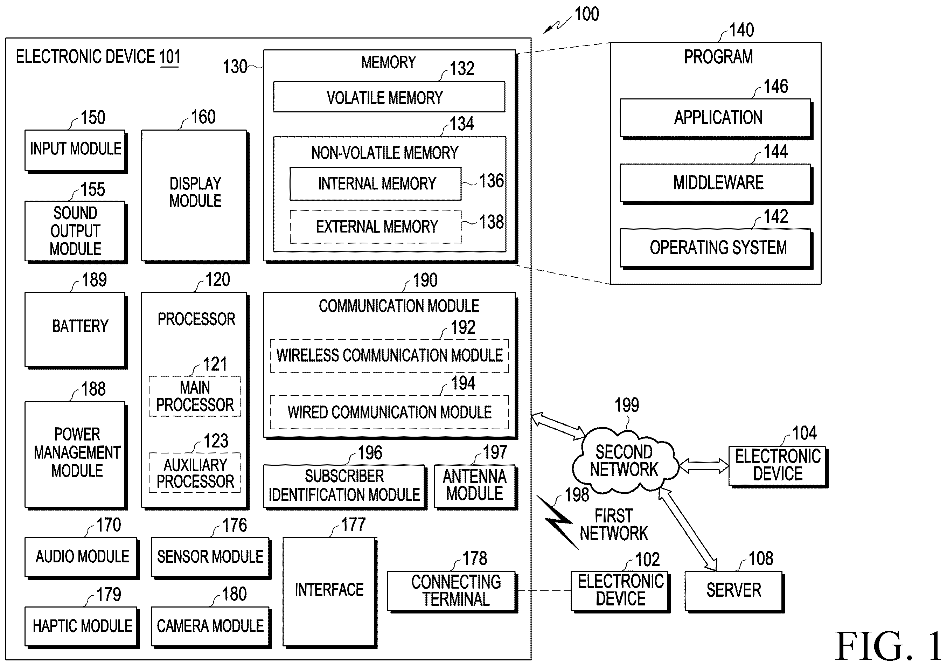

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device 101 via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mm Wave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device 101 according to various embodiments may be one of various types of electronic devices. The electronic devices 101 may include, for example, a portable communication device (e.g., a smartphone), a computer device, a portable multimedia device, a portable medical device, a camera, a wearable device, or a home appliance. According to an embodiment of the disclosure, the electronic devices 101 are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program) including one or more instructions that are stored in a storage medium (e.g., internal memory or external memory) that is readable by a machine (e.g., the electronic device 101). For example, a processor (e.g., the processor) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

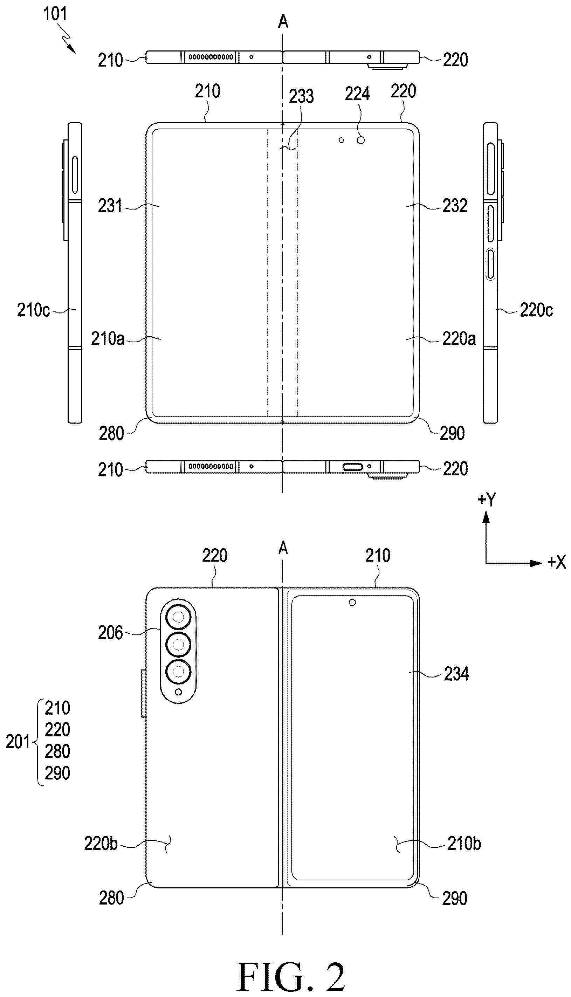

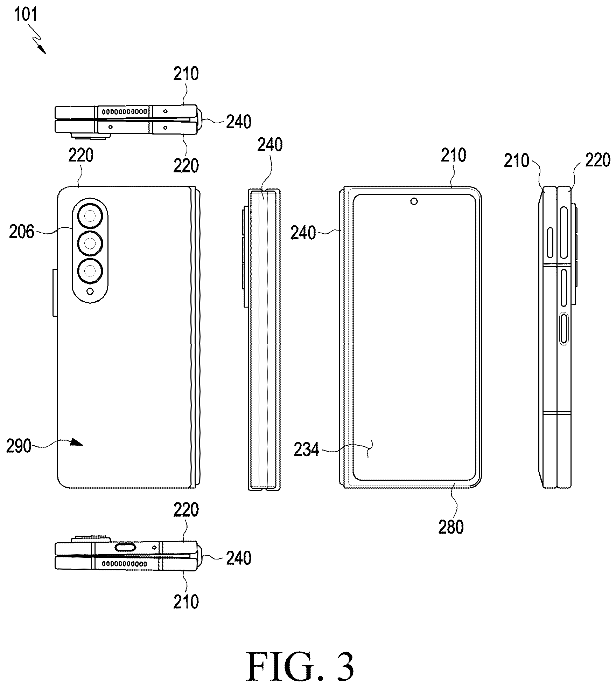

FIG. 2 is a view illustrating an electronic device according to an embodiment of the disclosure in an unfolded state. FIG. 3 is a view illustrating the electronic device according to an embodiment of the disclosure in a folded state.

Referring to FIGS. 2 and 3, an electronic device 101 may include a housing 201, a hinge cover 240 configured to cover a foldable portion of the housing 201, and a display 230 disposed in a space defined by the housing 201. According to an embodiment, the surface on which a screen output from the display 230 is exposed is defined as the front surface of the electronic device 101 (e.g., a first front surface 210a and a second front surface 220a). The surface opposite to the front surface is defined as the rear surface (e.g., a first rear surface 210b and a second rear surface 220b) of the electronic device 101. In addition, a surface surrounding the space between the front and rear surfaces is defined as the side surface (e.g., a first side surface 210c and a second side surface 220c) of the electronic device 101. The lateral side of the electronic device 101 may be the lateral side of at least one of the first housing 210 or the second housing 220. The electronic device 101 of FIGS. 2 and 3 may be referred to as a "foldable electronic device," a "portable electronic device," or a "portable foldable electronic device." According to an embodiment, the housing 201 may be referred to as a "foldable housing". The display 230 may be called a "flexible display."

According to an embodiment, the housing 201 may include a first housing 210, a second housing 220 rotatable with respect to the first housing 210, a first rear surface cover 280, and a second rear surface cover 290. The housing 201 of the electronic device 101 is not limited to the shape and assembly illustrated in FIGS. 2 and 3, but may be implemented by combinations and/or assemblies of other shapes or components. For example, in an embodiment, the first housing 210 and the first rear surface cover 280 may be integrally configured, and the second housing 220 and the second rear surface cover 290 may be integrally configured.

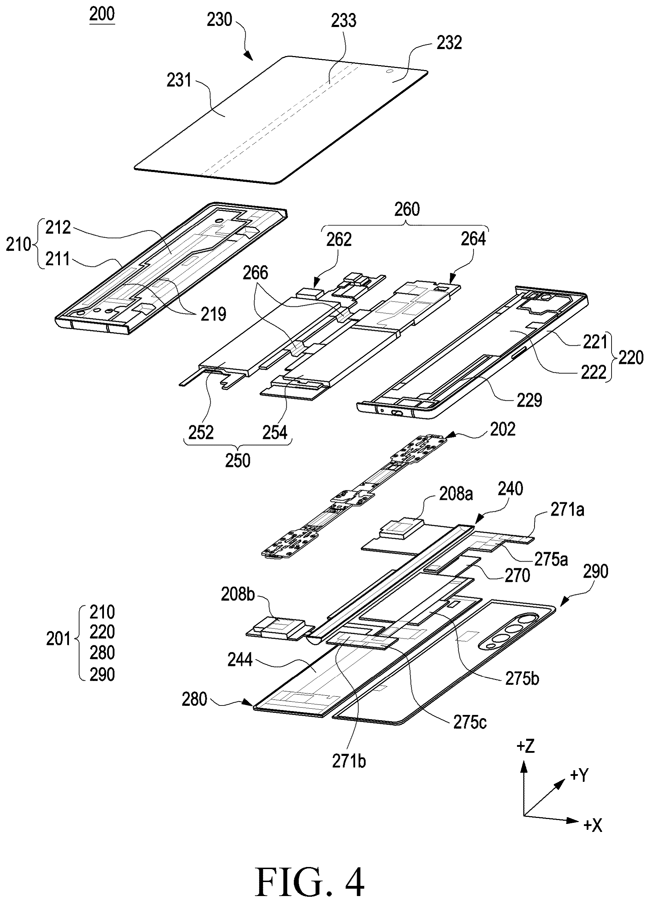

According to an embodiment, the first housing 210 may be connected to a hinge structure (e.g., the hinge assembly 202 of FIG. 4) and may include a first front surface 210a oriented in a first direction and a first rear surface 210b oriented in a second direction opposite to the first direction. The second housing 220 may include a second front surface 220a connected to the hinge assembly 202 and oriented in a third direction, and a second rear surface 220b oriented in a fourth direction opposite to the third direction, and the second housing 220 may rotate relative to the first housing 210 about the hinge assembly 202. Accordingly, the electronic device 101 may be changed to a folded state or an unfolded state. When the electronic device 101 is in the folded state, the first front surface 210a may face the second front surface 220a, and when the electronic device 101 is in the unfolded state, the third direction may be the same as the first direction. Hereinbelow, unless otherwise stated, directions will be described with reference to the unfolded state of the electronic device 101.

According to an embodiment, the first housing 210 and the second housing 220 may be disposed on opposite sides about the folding axis A and may have generally symmetrical shapes with respect to the folding axis A. As will be described later, the angle or distance between the first housing 210 and the second housing 220 may vary depending on whether the electronic device 101 is in the unfolded state, in the folded state, or in the intermediate state. According to an embodiment, the second housing 220 additionally includes a sensor area 224 where sensors (e.g., a front camera) are disposed, but the second housing 220 may have a mutually symmetrical shape in other areas.

According to an embodiment, the folding axis A may be a plurality of (e.g., two) parallel folding axes. In the disclosure, the folding axis A is provided along the longitudinal direction (the Y-axis direction) of the electronic device 101, but the direction of the folding axis A is not limited thereto. For example (not illustrated), the electronic device 101 may include a folding axis A extending along the width direction (e.g., the X-axis direction).

According to an embodiment, the electronic device 101 may include a structure to which a digital pen can be attached. For example, the electronic device 101 may include a magnetic body configured to attach the digital pen to the side surface of the first housing 210 or the side surface of the second housing 220. According to an embodiment, the electronic device 101 may include a structure into which a digital pen is insertable. For example, a hole (not illustrated) into which the digital pen is insertable may be provided in the side surface of the first housing 210 or the side surface of the second housing 220 of the electronic device 101.

According to an embodiment, the first housing 210 and the second housing 220 may be at least partially made of a metal or non-metal material having rigidity in a level selected in order to support the display 230. The at least a portion made of the metal material may provide a ground plane of the electronic device 101, and may be electrically connected to a ground line provided on a printed circuit board (e.g., the board unit 260 in FIG. 4).

According to an embodiment, the sensor area 224 may be defined to have a predetermined area adjacent to an edge or a corner of the second housing 220. However, the arrangement, shape, and size of the sensor area 224 are not limited to the illustrated example. For example, in other embodiments, the sensor area 224 may be provided at another corner or at any area between the upper and lower end corners in the second housing 220 or in the first housing 210. In an embodiment, components embedded in the electronic device 101 to carry out various functions may be exposed on the front surface of the electronic device 101 through the sensor area 224 or through one or more openings provided in the sensor area 224. In various embodiments, the components may include various types of sensors. The sensors may include, for example, at least one of a front camera, a receiver, or a proximity sensor.

According to an embodiment, the first rear surface cover 280 may be disposed on the rear surface of the electronic device 101 on one side of the folding axis A and may have, for example, a substantially rectangular periphery, which may be surrounded by the first housing 210. Similarly, the second rear surface cover 290 may be arranged on the other side of the folding axis A of the rear surface of the electronic device 101, and the periphery of the second rear surface cover 290 may be enclosed by the second housing 220.

According to an embodiment, the first rear surface cover 280 and the second rear surface cover 290 may have substantially symmetrical shapes about the folding axis (the axis A). However, the first rear surface cover 280 and the second rear surface cover 290 do not necessarily have mutually symmetrical shapes, and in another embodiment, the electronic device 101 may include a first rear surface cover 280 and a second rear surface cover 290 having various shapes.

According to an embodiment, the first rear surface cover 280, the second rear surface cover 290, the first housing 210, and the second housing 220 may define a space in which various components (e.g., a printed circuit board or a battery) of the electronic device 101 may be disposed. According to an embodiment, one or more components may be disposed or visually exposed on the rear surface of the electronic device 101. For example, at least a portion of the sub-display (e.g., the sub-display 244 in FIG. 4) may be visually exposed through at least a portion of the first rear surface cover 280. In another embodiment, one or more components or sensors may be visually exposed through at least a portion of the second rear surface cover 290. In various embodiments, the sensors may include a proximity sensor and/or a camera module 206 (e.g., a rear camera).

According to an embodiment, a front camera exposed to the front surface of the electronic device 101 through one or more openings provided in the sensor area 224 or a camera module 206 exposed through at least a portion of the second rear surface cover 290 may include one or more lenses, an image sensor, and/or an image signal processor. In some embodiments, two or more lenses (e.g., an infrared camera, a wide-angle lens, and a telephoto lens), and image sensors may be arranged on one side surface of the electronic device 101.

According to an embodiment, the hinge cover 240 is disposed between the first housing 210 and the second housing 220 and may cover internal components (e.g., the hinge assembly 202 in FIG. 4). According to an embodiment, the hinge cover 240 may be covered by a portion of the first housing 210 and a portion of the second housing 220, or may be exposed to the outside depending on the state of the electronic device 101 (the unfolded state (flat state) or the folded state).

According to an embodiment, as illustrated in FIG. 2, when the electronic device 101 is in the unfolded state, the hinge cover 240 may not be exposed by being covered by the first housing 210 and the second housing 220. As another example, as illustrated in FIG. 3, when the electronic device 101 is in the folded state (e.g., the fully folded state), the hinge cover 240 may be exposed to the outside between the first housing 210 and the second housing 220. As another example, when the first housing 210 and the second housing 220 are in the intermediate state in which the first and second housings are folded with a certain angle therebetween, the hinge cover 240 may be partially exposed to the outside between the first housing 210 and the second housing 220. However, the region exposed in this case may be smaller than that in the fully folded state. According to an embodiment, the hinge cover 240 may include a curved surface.

According to an embodiment, the display 230 may be placed in the space defined by the housing 201. For example, the display 230 may be seated in a recess defined by the housing 201, and may constitute most of the front surface of the electronic device 101. Accordingly, the front surface of the electronic device 101 may include the display 230, and partial areas of the first housing 210 and the second housing 220, which are adjacent to the display 230. The rear surface of the electronic device 101 may include the first rear surface cover 280, a partial area of the first housing 210 adjacent to the first rear surface cover 280, the second rear surface cover 290, and a partial area of the second housing 220 adjacent to the second rear surface cover 290.

According to an embodiment, the display 230 may include a plurality of displays spaced apart from each other. For example, the display 230 may include a first display area 231 disposed on the first housing 210 and a second display area 232 disposed on the second housing 220. According to an embodiment, the first display area 231 and the second display area 232 may be rotatable about the folding axis A.

According to an embodiment, the display 230 may refer to a display that is at least partially deformable into a planar surface or a curved surface. For example, the display 230 may be a foldable or flexible display. According to an embodiment, the display 230 may include a folding area 233, a first display area 231 disposed on one side of the folding area 233 (e.g., the left side of the folding area 233 illustrated in FIG. 2), and a second display area 232 disposed on the other side of the folding area 233 (e.g., the right side of the folding area 233 illustrated in FIG. 2). However, the area division of the display 230 is exemplary, and the display 230 may be divided into a plurality of areas (e.g., four or more areas or two areas) depending on the structure or functions thereof. For example, in the embodiment illustrated in FIG. 2, the area of the display 230 may be divided by the folding area 233 or the folding axis (the axis A) extending parallel to the Y axis. However, in another embodiment, the area of the display 230 may be divided based on another folding area (e.g., a folding area parallel to the X axis) or another folding axis (e.g., a folding axis parallel to the X axis). According to an embodiment, the display 230 may be coupled to or disposed adjacent to a touch-sensitive circuit, a pressure sensor that is capable of measuring touch intensity (pressure), and/or a digitizer (not illustrated) configured to detect a magnetic field-type stylus pen.

According to an embodiment, the first display area 231 and the second display area 232 may have generally symmetrical shapes about the folding area 233. According to an embodiment (not illustrated), unlike the first display area 231, the second display area 232 may include a notch cut due to the presence of the sensor area 224, but may have a shape symmetrical to the first display area 231 in areas other than the sensor area. In other words, the first display area 231 and the second display area 232 may include portions having mutually symmetrical shapes and portions having mutually asymmetrical shapes.

Hereinafter, the operations of the first housing 210 and the second housing 220 depending on the states of the electronic device 101 (e.g., a flat or unfolded state and a folded state) and respective areas of the display 230 will be described.

According to an embodiment, when the electronic device 101 is in the unfolded state (the flat state) (e.g., FIG. 2), the first housing 210 and the second housing 220 may be disposed to substantially form an angle of 180 degrees therebetween and to be oriented in the same direction. The surface of the first display area 231 and the surface of the second display area 232 of the display 230 may form 180 degrees therebetween and may be oriented in the same direction (e.g., the front direction of the electronic device). The folding area 233 may define the same plane as the first display area 231 and the second display area 232.

According to an embodiment, when the electronic device 101 is in the folded state (e.g., FIG. 3), the first housing 210 and the second housing 220 may be disposed to face each other. The surface of the first display area 231 and the surface of the second display area 232 of the display 230 may face each other while forming a narrow angle (e.g., between 0 degrees and 10 degrees) therebetween. At least a portion of the folding region 233 may be formed as a curved surface with a predetermined curvature.

According to an embodiment, when the electronic device 101 is in the intermediate state (not illustrated), the first housing 210 and the second housing 220 may be disposed to form a certain angle therebetween. The surface of the first display area 231 and the surface of the second display area 232 of the display 230 may form an angle greater than that in the folded state and smaller than that in the unfolded state. At least a portion of the folding area 233 may form a curved surface having a predetermined curvature, and the curvature in this case may be smaller than that in the folded state.

According to an embodiment, key input devices 217 may be disposed on the front surface of the foldable housing 201 (e.g., the first surface 210a and the second surface 220a). According to an embodiment, the key input devices 217 may be disposed on a side surface (e.g., the first side surface 210c and the second side surface 220ca). In another embodiment, the electronic device 101 may not include some or all of the above-described key input devices 217, and a key input device 217 not included may be implemented in another form, such as a soft key on the display 301.

FIG. 4 is an exploded perspective view of an electronic device according to an embodiment of the disclosure.

Referring to FIG. 4, the electronic device 101 may include a housing 201, a display 230, a hinge assembly 202, a battery 250, and a board unit 260. The housing 201 may include a first housing 210, a second housing 220, a first rear surface cover 280, and a second rear surface cover 290. The configuration of the first housing 210, the second housing 220, the hinge cover 240, the first rear surface cover 280, and the second rear surface cover 290 of FIG. 4 may be wholly or partly the same as the configuration of the first housing 210, the second housing 220, the hinge cover 240, the first rear surface cover 280, and the second rear surface cover 290 in FIG. 2 and/or FIG. 3.

According to an embodiment, the first housing 210 and the second housing 220 may be assembled to each other to be coupled to opposite sides of the hinge assembly 202. According to an embodiment, the first housing 210 may include a first support area 212 capable of supporting components (e.g., the first circuit board 262 and/or the first battery 252) of the electronic device 101 and a first side wall 211 surrounding at least a portion of the first support area 212. The first side wall 211 may include a first side surface (e.g., the first side surface 210c in FIG. 2) of the electronic device 101. According to an embodiment, the second housing 220 may include a second support area 222 capable of supporting components (e.g., the second circuit board 264 and/or the second battery 254) of the electronic device 101 and a second side wall 221 surrounding at least a portion of the second support area 222. The second side wall 221 may include a second lateral side (e.g., the second lateral side 220c in FIG. 2) of the electronic device 101.

According to an embodiment, the first housing 210 may include a first waterproofing member 219. The second housing 220 may include a second waterproofing member 229. The first waterproofing member 219 may be disposed in the first support area 212. The second waterproofing member 229 may be disposed in the second support area 222.

According to an embodiment, the display 230 may include a first display area 231, a second display area 232, a folding area 233, and a sub-display 244. The configuration of the first display area 231, the second display area 232, and the folding area 233 in FIG. 3 may be wholly or partly the same as or similar to the configuration of the first display area 231, the second display area 232, and the folding area 233 in FIG. 1 and/or FIG. 2.

According to an embodiment, the sub-display 244 may display a screen in a different direction from the display areas 231 and 232. For example, the sub-display 234 may output a screen in a direction opposite to the first display area 231. According to an embodiment, the sub-display 234 may be disposed on the first rear surface cover 280.

According to an embodiment, the battery 250 may include a first battery 252 disposed in the first housing 210 and a second battery 254 disposed in the second housing 220. According to an embodiment, the first battery 252 may be connected to a first circuit board 262, and the second battery 254 may be connected to a second circuit board 264. According to an embodiment, the battery 250 may supply power to at least one component of the electronic device 101. According to an embodiment, the battery 250 may include, for example, a non-rechargeable primary cell, a rechargeable secondary cell, or a fuel cell.

According to an embodiment, the board unit 260 may include the first circuit board 262 disposed within the first housing 210 and the second circuit board 264 disposed within the second housing 220. According to an embodiment, the first circuit board 262 and the second circuit board 264 may be electrically connected to each other by at least one flexible circuit board 266. According to an embodiment, at least a portion of flexible circuit board 266 may be disposed across hinge assembly 202. According to an embodiment, the first circuit board 262 and the second circuit board 264 may be disposed inside a space defined by the first housing 210, the second housing 220, the first rear surface cover 280, and the second rear surface cover 290. Components for implementing various functions of the electronic device 101 may be mounted on the first circuit board 262 and the second circuit board 264.

According to an embodiment, the electronic device 101 may include speakers 208a and 208b. According to an embodiment, the speakers 208a and 2008b may convert electrical signals into sound. According to an embodiment, the speakers 208a and 208b may be disposed inside the space defined by the first housing 210, the second housing 220, the first rear surface cover 280, and the second rear surface cover 290. According to an embodiment, the speakers 208a and 208b may include an upper speaker 208a located in an upper portion (the +Y direction) of the electronic device 101 and a lower speaker 208b located in the lower portion (the -Y direction) of the electronic device 101. In the disclosure, the speakers 208a and 208b are illustrated as being located within one housing (e.g., the first housing 210 in FIG. 4), but this is an optional structure. For example, the speakers 208a and 208b may be located within at least one of the first housing 210 or the second housing 220. The configuration of the speakers 208a and 208b in FIG. 4 may be wholly or partly the same as the configuration of the sound output module 155 in FIG. 1.

According to an embodiment, the electronic device 101 may include a rear member 270 (or a rear case). According to an embodiment, the rear member 270 may be disposed within the housing 201 (e.g., the second housing 220). According to an embodiment, the rear member 270 may accommodate at least one antenna 275.

According to an embodiment, the electronic device 101 may include an antenna 275. The antennas 275a and 275b may include, for example, an ultrawide band (UWB) antenna 275a, a near field communication (NFC) antenna, a wireless charging antenna, and/or a magnetic secure transmission (MST) antenna 275b. For example, the antenna 275 may execute short-range communication with an external device or may transmit/receive power required for charging to/from an external device in a wireless manner.

In an embodiment, an antenna structure may be provided by portions of the housing 201 or a combination thereof. For example, the antenna 275 may include a communication antenna 275c that is at least partially exposed to the outside of the electronic device 101 and defines at least a portion of the outside of the electronic device 101. The communication antenna 275c may be used for communication (e.g., Wi-Fi) with an external electronic device. The communication antenna 275c may be connected to an upper portion 271a or a lower portion 271b of the rear member 270.

In the following detailed description, a pair of housings may be exemplified with respect to a configuration in which the housings are rotatably coupled to each other by a hinge structure. It is noted that an electronic device according to various embodiments disclosed herein is not limited by the embodiments. For example, an electronic device according to various embodiments disclosed herein may include three or more housings, and the "a pair of housings" in the embodiments disclosed below may mean "two housings rotatably coupled to each other among three or more housings."

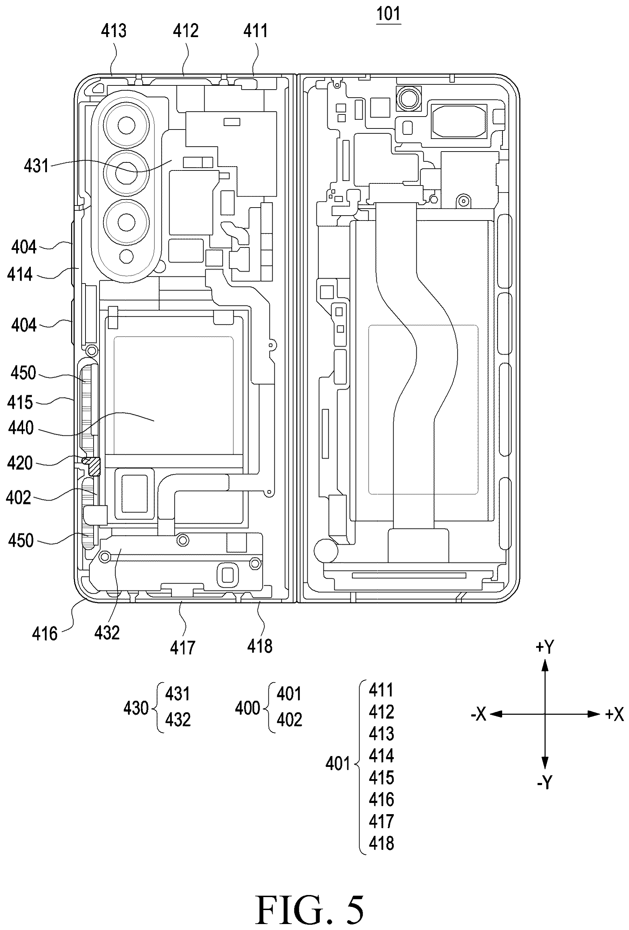

FIG. 5 is a view illustrating an unfolded state of an electronic device 101 according to an embodiment of the disclosure, with internal components mounted therein.

Referring to FIG. 5, the electronic device 101 may include a foldable housing 400 (hereinafter, housing 400) configured to accommodate components of the electronic device 101, a key input device 404, a printed circuit board 430, a battery 440, and a magnet 450. The electronic device 101 may further include an antenna structure, and at least one component of the antenna structure (e.g., a first conductive portion 401) may be formed in an area of the housing 400. The electronic device 101 may further include various components (e.g., a camera module) disposed within the housing 400.

The configurations of the housing 400, key input device 404, printed circuit board 430, and battery 440 in FIG. 5 may be partially or wholly the same as the configurations of the housing 201, key input device 217, printed circuit board 260, and battery 189 in FIGS. 1 to 4. The components in FIG. 5 may be selectively combined with the components in FIGS. 1 to 4.

According to an embodiment, referring to FIG. 5, the housing 400 may be defined as either a first housing (e.g., the first housing 210 in FIG. 2) or a second housing (e.g., the second housing 220 in FIG. 2) of the foldable housing 400. However, the housing 400 is not limited to a foldable housing and may be variously modified in design.

According to an embodiment, the housing 400 may form an exterior of the electronic device 101 and may include a first conductive portion 401 that forms at least a portion of a side wall of the electronic device 101. According to an embodiment, the first conductive portion 401 of the housing may form a peripheral side surface of the electronic device 101 and may serve as a side exterior. According to an embodiment, at least one member may be disposed on the first conductive portion 401, which is an outer surface of the electronic device 101. For example, a plurality of key input devices 404 may be disposed on the first conductive portion 401 of the housing. According to an embodiment, the key input devices 404 may have a fingerprint recognition sensor function. However, various sensor modules (e.g., an HRM sensor) may be substituted for or arranged together with the fingerprint recognition sensor.

According to an embodiment, the side wall may include the first conductive portion 401, which is a conductive structure, or a non-conductive structure.

According to an embodiment, the housing 400 may include a second conductive portion 402 that is disposed inside the side wall and forms a support member surrounded by the side wall. The second conductive portion 402 may be configured such that internal components of the electronic device 101, such as the printed circuit board 430, are mounted thereon, and may protect and support the internal components. The second conductive portion 402 may be electrically connected to a printed circuit board 430, which will be described later. According to an embodiment, the support member may include the second conductive portion 402, which is a conductive structure, or a non-conductive structure.

According to an embodiment, the first conductive portion 401 may include a metal material, and at least a portion thereof may be used as an antenna. According to an embodiment, the first conductive portion 401 may be at least one antenna segmented along at least a portion of the side wall. The first conductive portion 401, which may be used as an antenna using a metal frame, may include one or more portions (e.g., 411, 412, 413, 414, 415, 416, 417, and 418 in FIG. 5) along the side wall of the housing 400.

According to an embodiment, the antenna may be configured using single-band and/or multi-band antenna structures. As an example of communication bands that may be covered by the antenna, a typical antenna used in the electronic device 101 may have a PIFA or monopole radiator as a basic structure, and the volume and number of antennas to be mounted may be determined according to the service frequency, bandwidth, and type. Typically, the low-frequency band (low band) of 700 MHz to 900 MHz, the mid band of 1,700 MHz to 2,100 MHz, and the high-frequency band (high band) of 2,300 MHz to 2,700 MHz are used as major communication bands, and various wireless communication services such as Bluetooth (BT), GPS, and Wi-Fi may be additionally used. As another example, service bands with similar frequency ranges may be grouped and designed to be separated into multiple antennas. For example, in the case of a first antenna (main antenna) responsible for the primary communication of the device, such as voice/data communication (e.g., GPRS, WCDMA, and LTE), the antenna may be positioned at a lower portion of the electronic device 101 (e.g., in the - Y axis direction of FIG. 5), where fewer metal components that interfere with antenna performance are present, and may support a total of 24 frequency bands, including, for example, 2G (GSM850, EGSM, DCS, PCS), WCDMA (B1, B2, B5, B8), and LTE (B1, B2, B3, B4, B5, B7, B8, B12, B17, B18, B19, B20, B26, B38, B39, B40, B41). According to an embodiment, the electronic device 101 may implement antennas by grouping service bands with similar frequency ranges across two areas. For example, 2G (GSM850, EGSM, DCS, PCS), WCDMA (B1, B2, B5, B8), and LTE (B1, B2, B3, B4, B5, B8, B12, B17, B18, B19, B20, B26, B39) may be implemented in a first antenna (main antenna), and antennas for LTE (B7, B38, B40, B41) may be designed in a second antenna (sub-antenna).

According to an embodiment, the first conductive portion 401 may be disposed along the side wall. According to an embodiment, the first conductive portion 401 may include (1-1)^{th} conductive portions 411, 412, 413, 414, 416, 417, and 418 that overlap at least one surface of the printed circuit board 430 and may be physically connected to the printed circuit board 430, and a (1-2)^{th} conductive portion 415 that is not in contact with the printed circuit board 430 and may be difficult to physically connect to the printed circuit board 430.

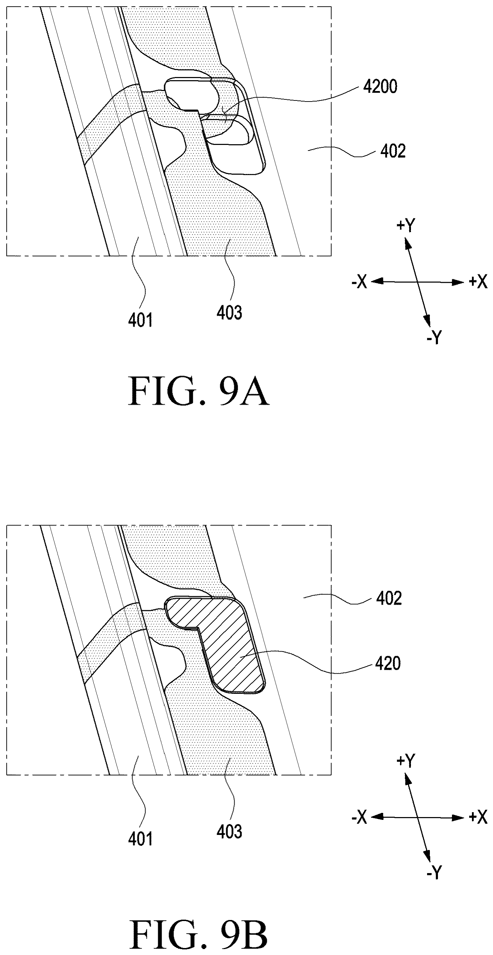

According to an embodiment, the (1-2)^{th} conductive portion 415 and the second conductive portion 402 may be spaced apart from each other. For example, the (1-2)^{th} conductive portion 415 and the second conductive portion 402 may be integrated. According to an embodiment, a non-conductive portion 403 (see FIG. 9A) may be disposed between the first conductive portion 401 and the second conductive portion 402. For example, a non-conductive portion 403 may be disposed between the (1-2)^{th} conductive portion 415 and the second conductive portion 402. For example, a non-conductive portion 403 may be disposed between the (1-2)^{th} conductive portion 415 and the (1-1)^{th} conductive portion 416. The non-conductive portion 403 may be, for example, an injection-molded product.

According to an embodiment, the electronic device 101 may include a printed circuit board 430 disposed on a support member. The printed circuit board 430 may include a first printed circuit board 431 positioned in an upper area within the housing (e.g., in the +Y-axis direction of FIG. 5) and a second printed circuit board 432 positioned in a lower area within the housing (e.g., in the -Y-axis direction of FIG. 5). According to an embodiment, the (1-1)^{th} conductive portions 411, 412, 413, 414, 416, 417, and 418 may be disposed adjacent to the first printed circuit board 431 or the second printed circuit board 432. The (1-1)^{th} conductive portions 411, 412, 413, 414, 416, 417, and 418 may be electrically connected to the first printed circuit board 431 or the second printed circuit board 432. For example, the (1-1)^{th} conductive portions 411, 412, 413, 414, 416, 417, and 418 may be connected to an antenna contact element, and the antenna contact element may be connected to a multi-layer ceramic capacitor (MLCC) or a varistor for preventing leakage current, which is disposed on the first printed circuit board 430 or the second printed circuit board 430, so as to prevent the housing 400 from being corroded by leakage current.

According to an embodiment, the electronic device 101 may include a battery 440 disposed on a support member. The battery 440 may be disposed between the first printed circuit board 431 and the second printed circuit board 432. According to an embodiment, the battery 440 may be disposed adjacent to the (1-2)^{th} conductive portion 415 of the first conductive portion 401. According to an embodiment, at least one surface of the battery 440 may be in contact with the (1-2)^{th} conductive portion 415. Since the (1-2)^{th} conductive portion 415 is disposed adjacent to the battery 440 rather than the printed circuit board 430, it may be difficult to be physically connected to the printed circuit board 430. According to an embodiment of the disclosure, the (1-2)^{th} conductive portion 415 may be connected to the second conductive portion 402, which is connected to the printed circuit board 430 via a connecting member 420.

According to an embodiment, the magnet 450 may be disposed in each housing to maintain the folded state by the attraction of the magnet 450 when the foldable housing 400 is in the folded state. According to an embodiment, at least one magnet 450 may be disposed between the side wall of the housing and the battery 440. The magnet 450 may be disposed between the (1-2)^{th} conductive portion 415 of the first conductive portion 401 and the battery 440. Since the (1-2)^{th} conductive portion 415 is disposed adjacent to the magnet 450 and the battery 440, rather than the printed circuit board 430, it may be difficult to connect the (1-2)^{th} conductive portion 415 to the printed circuit board 430 in terms of layout, using a flexible printed circuit board. According to an embodiment of the disclosure, the (1-2)^{th} conductive portion 415 may be connected to the second conductive portion 402, which is connected to the printed circuit board 430 via a connecting member 420.

According to an embodiment, the (1-2)^{th} conductive portion 415 may be disposed adjacent to the battery 440 positioned between the first printed circuit board 430 and the second printed circuit board 430. The (1-2)^{th} conductive portion 440 may not be disposed adjacent to either the first printed circuit board 430 or the second printed circuit board 430, and thus may be difficult to physically connect. According to an embodiment of the disclosure, the electronic device 101 may further include a connecting member 420 to prevent the housing 400, which includes the (1-2)^{th} conductive portion 440, from being corroded due to leakage current.

Hereinafter, the configuration and structure of the connecting member 420 will be described in detail.

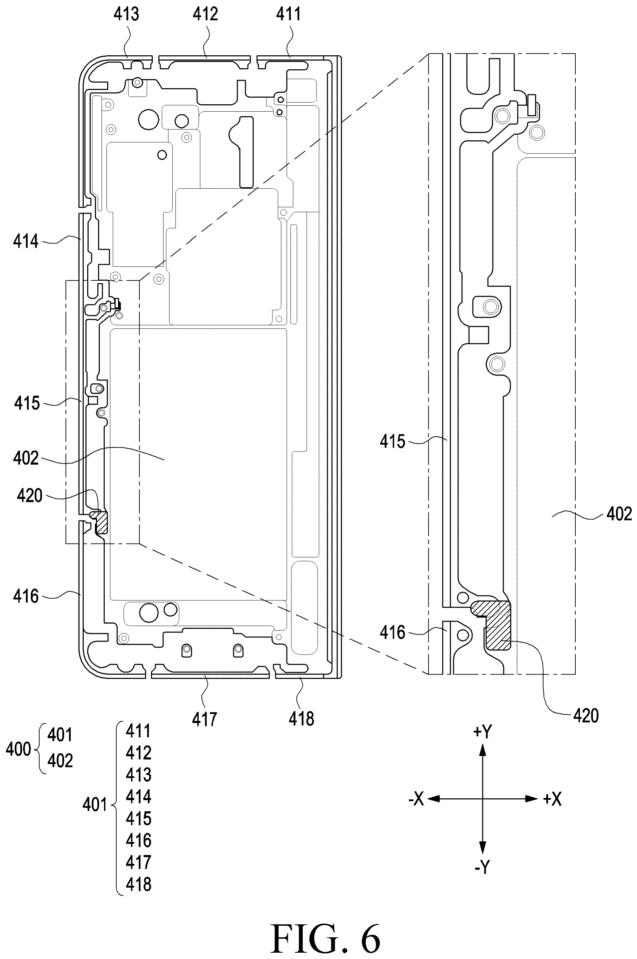

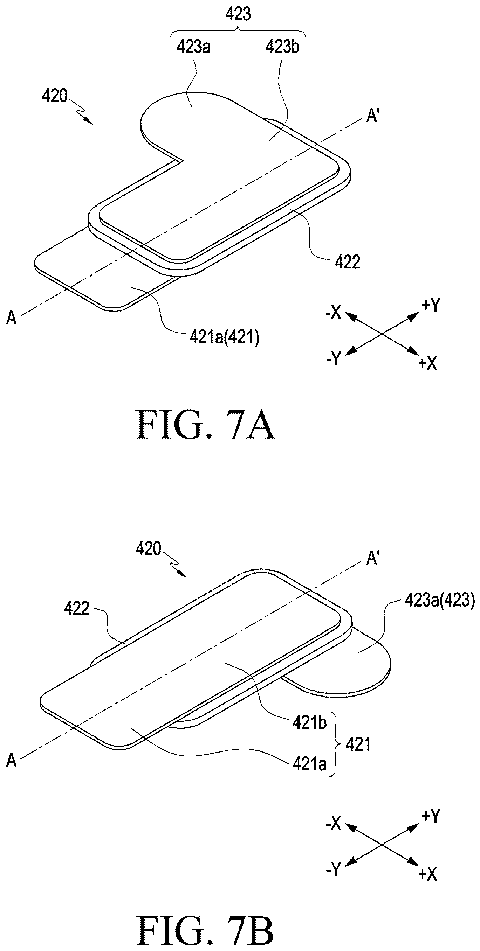

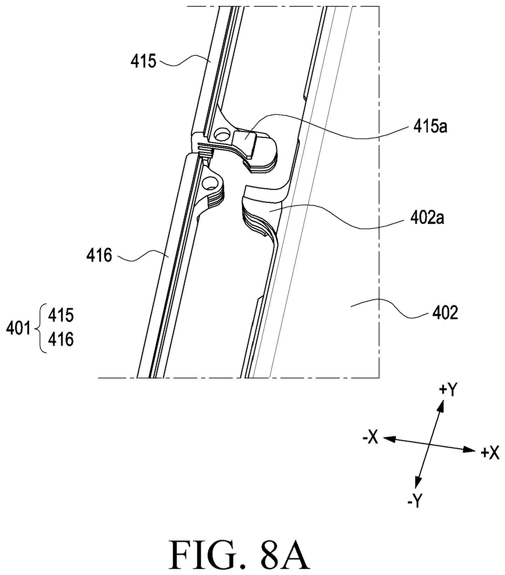

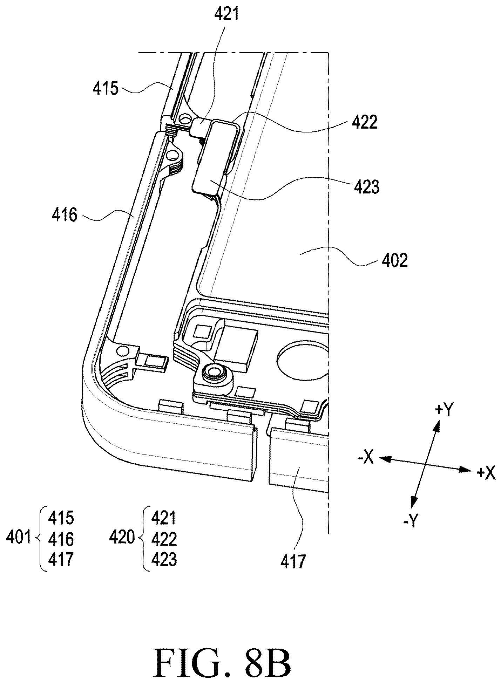

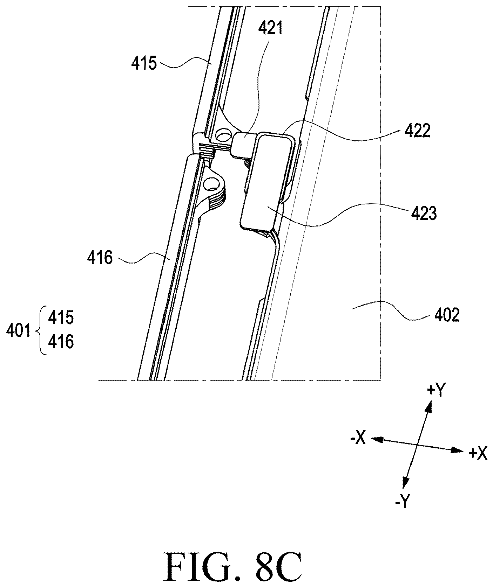

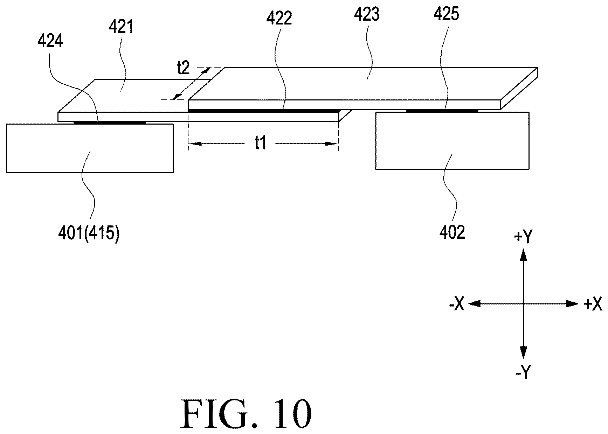

FIG. 6 is a view illustrating a conductive portion of a housing 400 and a connecting member 420 according to an embodiment of the disclosure. FIG. 6 excludes a non-conductive structure (e.g., the non-conductive portion 403 of FIG. 9A) for convenience of description. FIGS. 7A and 7B are front and rear perspective views of a connecting member 420 according to an embodiment of the disclosure. FIG. 8A is a view illustrating a state before the conductive portion of the housing 400 and the connecting member 420 are coupled, according to an embodiment of the disclosure. FIGS. 8B and 8C are views illustrating a state after the conductive portion of the housing 400 and the connecting member 420 are coupled, according to an embodiment of the disclosure. FIG. 9A is a view illustrating a state before the housing 400 and the connecting member 420 are coupled, according to an embodiment of the disclosure. FIG. 9B is a view illustrating a state after the housing 400 and the connecting member 420 are coupled, according to an embodiment of the disclosure. FIG. 10 is a cross-sectional view taken along line A-A' of FIG. 7A, illustrating the state in which the connecting member 420 and the housing are coupled.

Referring to FIGS. 6 to 10, an electronic device 101 may include a foldable housing 400 (hereinafter, referred to as "housing 400") configured to accommodate components of the electronic device 101, and a connecting member 420. The electronic device 101 may further include an antenna structure, and at least one component of the antenna structure (e.g., a first conductive portion 401) may be positioned in an area of the housing 400. The electronic device 101 may further include various components (e.g., a camera module) disposed within the housing 400.

The configuration of the housing 400 in FIGS. 6 to 10 may be partially or wholly the same as the configuration of the housing 201 in FIGS. 1 to 4. The structures of FIGS. 6 to 10 may be optionally combined with the structure of FIG. 5.

According to an embodiment, the connecting member 420 may be in contact with the first conductive portion 401 and the second conductive portion 402. The connecting member 420 may electrically connect the first conductive portion 401 and the second conductive portion 402. According to an embodiment, the connecting member 420 may electrically connect the (1-2)^{th} conductive portion 415 of the first conductive portion 401 and the second conductive portion 402. For example, the connecting member 420 may be in contact with an end of the (1-2)^{th} conductive portion 415 in the -Y-axis direction.

According to an embodiment, the connecting member 420 may have a capacitor structure configured to block DC current and allow AC current to pass therethrough for corrosion prevention and electric shock protection in relation to leakage current from the (1-2)^{th} conductive portion 415. According to an embodiment, in the connecting member 420, a voltage be applied between a first metal layer 421 and a second metal layer 423 due to a radiated current, and a negative charge and a positive charge may be induced respectively in the first metal layer 421 and the second metal layer 423. As a result, electrical energy may be stored due to the electrostatic attraction between the first metal layer 421 and the second metal layer 423, so that the connecting member 420 may perform substantially the same function as a capacitor.

According to an embodiment, the connecting member 420 may include a first metal layer 421 configured to be at least partially bonded to the second conductive portion 402, a second metal layer 423 configured to be at least partially bonded to the first conductive portion 401, and a dielectric layer 422 interposed between the first metal layer 421 and the second metal layer 423.

According to an embodiment, the first metal layer 421 may include a (1-1)^{th} area 421a in contact with the second conductive portion 402 and a (1-2)^{th} area 421b stacked with the dielectric layer 422. The second metal layer 423 may include a (2-1)^{th} area 423a in contact with the first conductive portion 401 and a (2-2)^{th} area 423b stacked with the dielectric layer 422. The dielectric layer 422 may be disposed between the (1-2)^{th} area 421b of the first metal layer 421 and the (2-2)^{th} area 423b of the second metal layer 423.

According to an embodiment, the first metal layer 421 may be bonded to be electrically connected to the second conductive portion 402. For example, the first metal layer 421 may be bonded to be electrically connected to a second protrusion 402a of the second conductive portion 402. The second protrusion 402a of the second conductive portion 402 may protrude in the -X-axis direction where the first conductive portion 401 is located. For example, the first metal layer 421 may be bonded to the second conductive portion 402 through a bonding method such as laser bonding or ultrasonic bonding. For example, the (1-1)^{th} area 421a of the first metal layer 421 may be bonded to the second conductive portion 402 through a bonding method such as laser bonding or ultrasonic bonding. The first metal layer 421 and the second conductive portion 402 may be bonded through a bonding method such as laser bonding or ultrasonic bonding, so that the function and shape of the electronic device 101 may be maintained even when the electronic device 101 is subjected to an impact such as a drop.

According to an embodiment, the second metal layer 423 may be bonded to be electrically connected to the first conductive portion 401. According to an embodiment, the second metal layer 423 may be bonded to be electrically connected to the (1-2)^{th} conductive portion 415. For example, the first metal layer 421 may be bonded to be electrically connected to a first protrusion 415a of the (1-2)^{th} conductive portion 415. The first protrusion 415a of the (1-2)^{th} conductive portion 415 may protrude in the +X-axis direction where the second conductive portion 402 is located. For example, the second metal layer 423 may be bonded to the first conductive portion 401 through a bonding method such as laser bonding or ultrasonic bonding. For example, the (2-1)^{th} area 423a of the second metal layer 423 may be bonded to the first conductive portion 401 through a bonding method such as laser bonding or ultrasonic bonding. The first metal layer 421 and the second conductive portion 402 may be bonded through a bonding method such as laser bonding or ultrasonic bonding, so that the function and shape of the electronic device 101 may be maintained even when the electronic device 101 is subjected to an impact such as a drop.

According to an embodiment, the capacitance of the connecting member 420 may be determined by the dielectric constant of the dielectric layer 422, and the distance and the overlapping area between the first metal layer 421 and the second metal layer 423. For example, the dielectric constant of the dielectric layer 422 according to an embodiment of the disclosure may be about 1.0 (F/m) or more and 5.0 (F/m) or less. For example, the dielectric constant of the dielectric layer 422 according to an embodiment of the disclosure may be about 3.0 (F/m). For example, the thickness of the dielectric layer 422 according to the disclosure may be about 0.005 mm or more and 0.015 mm or less. For example, the thickness of the dielectric layer 422 according to an embodiment of the disclosure may be about 0.01 mm. For example, the width (e.g., t1 in FIG. 9) or the length (e.g., t2 in FIG. 9) of the stacked portion of the connecting member 420 (e.g., the (1-2)^{th} area 421b of the first metal layer 421, the dielectric layer 422, and the (2-2)^{th} area 423b of the second metal layer 423) may be about 1 mm or more and 4 mm or less. For example, the width or the length of the stacked portion of the connecting member 420 (e.g., the (1-2)^{th} area 421b of the first metal layer 421, the dielectric layer 422, and the (2-2)^{th} area 423b of the second metal layer 423) according to an embodiment of the disclosure may be about 2 mm.

According to an embodiment, a recess 4200 corresponding to the shape of the connecting member 420 may be formed in a portion of the housing 400, which includes the first conductive portion 401, the second conductive portion 402, and the non-conductive portion 403, and is configured to be coupled to the connecting member 420. When the housing 400, which includes the first conductive portion 401, the second conductive portion 402, and the non-conductive portion 403, is coupled with the connecting member 420, a front surface of the electronic device 101 (e.g., a surface in the +Z-axis direction in FIG. 6) may be formed to be flat.

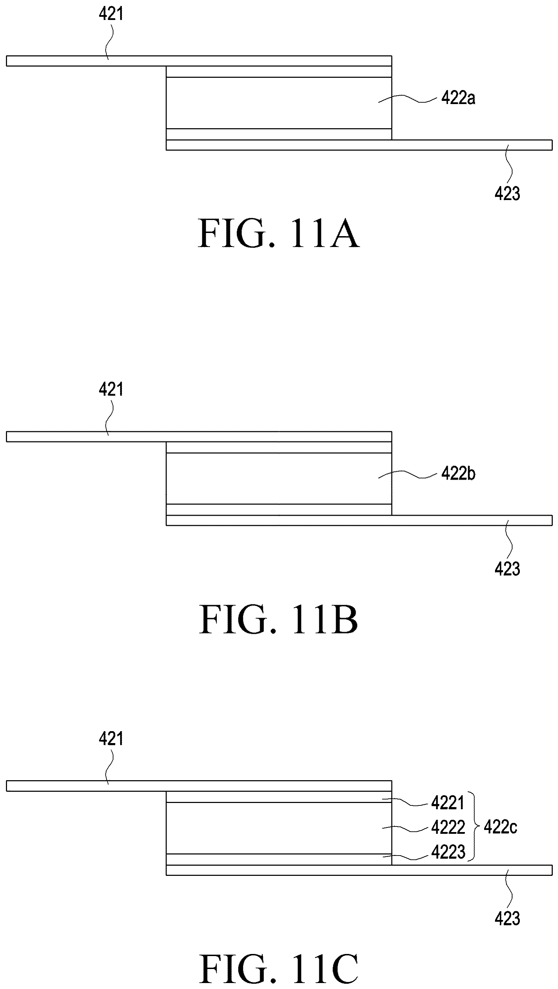

FIGS. 11A to 11C are views illustrating cross-sections of the connecting member 420 taken along line A-A' of FIG. 7B, according to an embodiment of the disclosure.

Referring to FIGS. 11A to 11C, the electronic device 101 may include a foldable housing 400 (hereinafter, referred to as the housing 400) configured to accommodate components of the electronic device 101, a key input device 404, a printed circuit board 430, a battery 440, and a magnet 450. The electronic device 101 may further include an antenna structure, and at least one component of the antenna structure (e.g., a first conductive portion 401) may be positioned in an area of the housing 400. The electronic device 101 may further include various components (e.g., a camera module) disposed within the housing 400.

The configurations of the housing 400, key input device 404, printed circuit board 430, and battery 440 in FIGS. 11A to 11C may be partially or wholly the same as the configurations of the housing 201, key input device 217, printed circuit board 260, and battery 189 in FIGS. 1 to 4. The structures of FIGS. 11A to 11C may be selectively combined with the structures of FIGS. 5 to 10.

According to an embodiment, referring to FIG. 11A, a dielectric layer 422a forming the connecting member 420 may be formed of a flexible copper clad layer (FCCL). For example, the dielectric layer 422a may be formed of a double-sided flexible copper clad layer (FCCL). The flexible copper clad layer (FCCL) may be formed by methods such as a casting method of coating a copper foil on a polyimide (PI) film, a sputtering method of depositing a copper foil, or an electroless plating method. For example, the capacitance of the dielectric layer 422a may be about 15 pF or more and 25 pF or less. For example, the capacitance of the dielectric layer 422a may be about 20 pF. For example, the dielectric layer 422a may have a thickness of about 15 µm or less. For example, the dielectric layer 422a may have a thickness of about 12 µm or less. According to an embodiment, the dielectric layer 422a may be attached to the first metal layer 421 and the second metal layer 423 through soldering (SMT). For example, the dielectric layer 422a may be attached to support members (not illustrated) disposed on upper and lower surfaces through soldering (SMT), and the support members (not illustrated) may be connected to the first metal layer 421 and the second metal layer 423 through laser welding.

According to an embodiment, referring to FIG. 11B, the dielectric layer 422b forming the connecting member 420 may be in a film form. For example, the dielectric layer 422b may have a thickness of about 40 µm or more and 60 µm or less. For example, the dielectric layer 422b may have a thickness of about 50 µm. The capacitance of the dielectric layer 422b according to this embodiment (FIG. 11B) may be higher than the capacitance of the dielectric layer 422a according to the previously described embodiment (FIG. 11A).

According to an embodiment, referring to FIG. 11C, the dielectric layer 422c forming the connecting member 420 may include metal sheets 4221 and 4223, and a bonding sheet 4222 disposed between the metal sheets. The dielectric layer 422c may be manufactured by hot pressing. For example, the dielectric layer 422c may be manufactured by hot pressing in which a weight of 45 kg is applied at a temperature of about 160 degrees C. For example, the dielectric layer 422c may have a thickness of about 10 µm or more and 20 µm or less.

According to an embodiment of the disclosure, the electronic device may include a housing including at least one first conductive portion (e.g., the (1-2)^{th} conductive portion 415 of FIG. 5) that is segmented along at least a portion of a side wall, and a second conductive portion disposed inside the side wall and spaced apart from the first conductive portion, a connecting member electrically connecting the first conductive portion and the second conductive portion; and a printed circuit board disposed within the housing and electrically connected to the first conductive portion through the connecting member. The connecting member may include a first metal layer configured to be bonded to at least a portion of the first conductive portion, a second metal layer configured to be bonded to at least a portion of the second conductive portion, and a dielectric layer disposed between the first metal layer and the second metal layer.

According to an embodiment, the first metal layer may include a (1-1)^{th} area 421a that is in contact with the first conductive portion and a (1-2)^{th} area 421b that is stacked with the dielectric layer, the second metal layer may include a (2-1)^{th} area 423a that is in contact with the second conductive portion and a (2-2)^{th} area 423b that is stacked with the dielectric layer, and the dielectric layer may be configured to be disposed between the (1-2)^{th} area of the first metal layer and the (2-2)^{th} area of the second metal layer.

According to an embodiment, the connecting member may be configured to block a DC current and to allow an AC current to pass therethrough.

According to an embodiment, the housing may further include a recess 4200 formed at a position coupled to the connecting member. The recess may have a shape corresponding to a shape of the connecting member.

According to an embodiment, the connecting member may include a flexible copper clad layer (FCCL).

According to an embodiment, the dielectric layer of the connecting member may include a first metal sheet 4221 being in contact with the first metal layer, a second metal sheet 4223 being in contact with the second metal layer, and a bonding sheet 4222 disposed between the first metal sheet and the second metal sheet.

According to an embodiment, the housing may further include a non-conductive portion 403 disposed between the first conductive portion and the second conductive portion.

According to an embodiment, the printed circuit board may include a first printed circuit board 431 positioned in an upper area within the housing, and a second printed circuit board 432 positioned in a lower area within the housing.

According to an embodiment, the electronic device may further include a battery 440 disposed on the second conductive portion, and the battery may be disposed adjacent to the first conductive portion.

According to an embodiment, the electronic device may further include a magnet 450 disposed between the first conductive portion and the battery.

According to an embodiment, the second conductive portion may be configured to be electrically connected to the printed circuit board.

According to an embodiment, the first conductive portion may be spaced apart from the printed circuit board.

According to an embodiment, the first metal layer may be configured to be bonded to the first conductive portion through at least one of laser bonding or ultrasonic bonding.

According to an embodiment, the second metal layer may be configured to be bonded to the second conductive portion through at least one of laser bonding or ultrasonic bonding.

According to an embodiment, at least one key input device may be disposed on the first conductive portion.

According to an embodiment of the disclosure, the electronic device may include a housing including at least one first conductive portion that is segmented along at least a portion of a side wall, and a second conductive portion disposed inside the side wall and spaced apart from the first conductive portion, a connecting member electrically connecting the first conductive portion and the second conductive portion, and a printed circuit board disposed within the housing and electrically connected to the first conductive portion through the connecting member. The connecting member may include a first metal layer configured to be bonded to at least a portion of the first conductive portion, a second metal layer configured to be bonded to at least a portion of the second conductive portion, and a dielectric layer disposed between the first metal layer and the second metal layer. The first metal layer may be configured to be bonded to the first conductive portion through at least one of laser bonding or ultrasonic bonding, and the second metal layer may be configured to be bonded to the second conductive portion through at least one of laser bonding or ultrasonic bonding.

According to an embodiment, the connecting member may be configured to block a DC current and to allow an AC current to pass therethrough.

According to an embodiment, the first metal layer may include a (1-1)^{th} area 421a that is in contact with the first conductive portion and a (1-2)^{th} area 421b that is stacked with the dielectric layer, the second metal layer may include a (2-1)^{th} area 423a that is in contact with the second conductive portion and a (2-2)^{th} area 423b that is stacked with the dielectric layer, and the dielectric layer may be configured to be disposed between the (1-2)^{th} area of the first metal layer and the (2-2)^{th} area of the second metal layer.

According to an embodiment, the housing may further include a recess 4200 formed at a position coupled to the connecting member. The recess may have a shape corresponding to a shape of the connecting member.

According to an embodiment, the connecting member may include a flexible copper clad layer (FCCL).

During use of a charger (e.g., a third-party fast charger) for charging an electronic device 101, when an electrolyte (e.g., sweat or water) enters the inside of a metal member of the electronic device 101 due to leakage current, oxidation (corrosion) of the metal member may occur. During this process, gas (e.g., hydrogen gas) generated by the corrosion may push against an anodizing layer and may cause delamination of the anodizing layer (leakage current-induced corrosion). To prevent this, a side wall housing including a fingerprint key and a support member may be configured to be separable. An antenna contact element may be disposed between a first conductive portion 401 (antenna) of a side wall on which the fingerprint key is disposed and a second conductive portion 402 forming at least a portion of a support member, and a multi-layer ceramic capacitor (MLCC) or a varistor for preventing leakage current after vertical or lateral contact may be mounted on a printed circuit board (PCB) 430 to block a DC current between the second conductive portion 402 and ground. However, in the case of an antenna that is not adjacent to the printed circuit board 430, blocking of current may be difficult.

In an electronic device 101 according to an embodiment of the disclosure, the first conductive portion 401 (antenna), on which the fingerprint key is disposed, may be physically separated from the second conductive portion 402 (support member), and may be electrically connected via a connecting member 420 that performs substantially the same function as a capacitor, so as to maintain antenna performance and to prevent electric shock or corrosion caused by leakage current.

## Claims

1. An electronic device comprising:
a housing (400) comprising at least one first conductive portion (e.g., the (1-2)^{th} conductive portion (415)) that is segmented along at least a portion of a side wall, and a second conductive portion (402) disposed inside the side wall and spaced apart from the first conductive portion;
a connecting member (420) electrically connecting the first conductive portion and the second conductive portion; and
a printed circuit board (430) disposed in the housing and electrically connected to the first conductive portion through the connecting member,
wherein the connecting member comprises:
a first metal layer (421) configured to be at least partially bonded to the first conductive portion,
a second metal layer (423) configured to be at least partially bonded to the second conductive portion, and
a dielectric layer (422) disposed between the first metal layer and the second metal layer.

2. The electronic device of claim 1, wherein the first metal layer comprises a (1-1)^{th} area (421a) that is in contact with the first conductive portion and a (1-2)^{th} area (421b) that is stacked with the dielectric layer,
wherein the second metal layer comprises a (2-1)^{th} area (423a) that is in contact with the second conductive portion and a (2-2)^{th} area (423b) that is stacked with the dielectric layer, and
wherein the dielectric layer is disposed between the (1-2)^{th} area of the first metal layer and the (2-2)^{th} area of the second metal layer.

3. The electronic device of any one of claims 1 and 2, wherein the connecting member is configured to block a DC current and to allow an AC current to pass therethrough.

4. The electronic device of any one of claims 1 to 3, wherein the housing further comprises a recess (4200) formed at a position coupled to the connecting member, the recess having a shape corresponding to a shape of the connecting member.

5. The electronic device of any one of claims 1 to 4, wherein the connecting member comprises a flexible copper clad layer (FCCL).

6. The electronic device of any one of claims 1 to 4, wherein the dielectric layer of the connecting member comprises:
a first metal sheet (4221) being in contact with the first metal layer,
a second metal sheet (4223) being in contact with the second metal layer, and
a bonding sheet (4222) disposed between the first metal sheet and the second metal sheet.

7. The electronic device of any one of claims 1 to 6, wherein the housing further comprises a non-conductive portion (403) disposed between the first conductive portion and the second conductive portion.

8. The electronic device of any one of claims 1 to 7, wherein the printed circuit board comprises:
a first printed circuit board (431) positioned in an upper area within the housing, and
a second printed circuit board (432) positioned in a lower area within the housing.

9. The electronic device of any one of claims 1 to 8, further comprising:
a battery (440) disposed on the second conductive portion,
wherein the battery is disposed adjacent to the first conductive portion.

10. The electronic device of claim 9, further comprising:
a magnet (450) disposed between the first conductive portion and the battery.

11. The electronic device of any one of claims 1 to 10, wherein the second conductive portion is configured to be electrically connected to the printed circuit board.

12. The electronic device of any one of claims 1 to 11, wherein the first conductive portion is spaced apart from the printed circuit board.

13. The electronic device of any one of claims 1 to 12, wherein the first metal layer is configured to be bonded to the first conductive portion through at least one of laser bonding or ultrasonic bonding.

14. The electronic device of any one of claims 1 to 13, wherein the second metal layer is configured to be bonded to the second conductive portion through at least one of laser bonding or ultrasonic bonding.

15. The electronic device of any one of claims 1 to 14, wherein at least one key input device is disposed on the first conductive portion.
